# EUROPEAN PATENT APPLICATION

(11) **EP 4 746 634 A1**
(43) Date of publication of application: **20.05.2026**
(21) Application number: 25215237.6
(22) Date of filing: 12.11.2025
(51) Int. Cl.: H10D 84/01, H10D 30/00, H10D 84/83, H10D 88/00, H10D 84/85

(54) **INTEGRATED CIRCUIT DEVICES INCLUDING STACKED TRANSISTORS IN Z-SHAPE SCHEME**

(30) Priority: 19.11.2024 US 202463722166 P; 16.09.2025 US 202519330094
(71) Applicant: Samsung Electronics Co., Ltd., Suwon-si, Gyeonggi-do 16677 (KR)
(72) Inventor: PARK, Young Gook, San Jose, CA, 95134 (US); LIM, Jinyoung, San Jose, CA, 95134 (US); SHIN, Hyo Jong, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

An integrated circuit device may include a substrate (100) and a cell structure on an upper surface of the substrate (100). The cell structure may comprise a first transistor (102) that comprises a first sidewall and a second sidewall that is opposite to the first sidewall in a first direction (D1) that is parallel with the upper surface of the substrate (100) and a second transistor (108) that comprises a third sidewall and a fourth sidewall that is opposite to the third sidewall in the first direction (D1) between the upper surface of the substrate (100) and the first transistor (102) in a second direction (D3) that is perpendicular to the upper surface of the substrate (100). One of the third sidewall and the fourth sidewall may overlap the first transistor (102) in the second direction (D3).

## Description

### BACKGROUND

The present disclosure generally relates to the field of integrated circuit devices and, more particularly, to integrated circuit devices including stacked transistors.

Various structures of an integrated circuit device and methods of forming the same have been proposed to increase the integration degree of the integrated circuit device. For example, a stacked transistor structure including multiple transistors vertically stacked has been proposed.

The stacked transistor structure may be in an I-shape scheme or an L-shape scheme in a cross-sectional view. In the I-shape scheme, an upper transistor and a lower transistor may have (substantially) the same size (e.g., (substantially) the same cell height or (substantially) the same channel width) and may be aligned with each other in a horizontal direction. In the L-shape scheme, an upper transistor and a lower transistor may have different sizes (e.g., different cell heights or different channel widths) from each other. In the L-shape scheme, one of sidewalls of the upper transistor and one of sidewalls of the lower transistor may be aligned in a horizontal direction.

In the I-shape scheme and the L-shape scheme, a middle-of-line (MOL) structure positioned between the upper transistor and/or the lower transistor and an adjacent cell boundary in a horizontal direction may be needed to provide connectivity (e.g., electrical connectivity) among front-side conductive tracks (e.g., front-side power delivery network and/or front-side signal tracks on an upper surface of the upper transistor), back-side conductive tracks (e.g., back-side power delivery network and/or back-side signal tracks on a lower surface of the lower transistor), the upper transistor, and the lower transistor because the upper transistor and the lower transistor substantially or completely overlap with each other in the vertical direction and may not have enough space on which the front-side conductive tracks and the back-side conductive tracks land through conductive contacts and/or conductive vias in the vertical direction. In summary, the I-shape scheme and the L-shape scheme may need extra space for the MOL structure adjacent the upper transistor and/or the lower transistor (e.g., between the transistor(s) and an adjacent cell boundary), and therefore, the overall footprint of the integrated circuit device may increase, and the integration degree of the integrated circuit device may be limited. Also, the MOL structure may impose limitations on the availability of the front-side and back-side conductive tracks, congestion of the interconnection among the device elements, and restriction on cell structure arrangement direction.

### SUMMARY

An aspect of the present disclosure is to provide a Z-shape scheme for a stacked transistor structure. In the Z-shape scheme, the upper transistor and the lower transistor may be staggered with respect to each other (in a horizontal direction). In other words, the upper transistor and the lower transistor in the Z-shape scheme may be positioned in a zigzag arrangement.

In the Z-shape scheme, (some elements of) the MOL structure may be positioned to be (completely) overlapped by the upper transistor and/or the lower transistor in the vertical direction because the upper transistor and the lower transistor have less overlap with each other in the vertical direction. In other words, the MOL structure may be provided in the areas overlapping the upper transistor and/or the lower transistor in the vertical direction rather than in the areas adjacent (sidewalls of) the upper transistor and/or the lower transistor (e.g., in the areas between the upper transistor and/or the lower transistor and an adjacent cell boundary in a horizontal direction). As a result, the front-side conductive tracks and back-side conductive tracks may be electrically connected to the target transistor (e.g., the upper transistor and the lower transistor) without a detour (e.g., a detour through the area between the target transistor and the adjacent cell boundary in a horizontal direction), and the integration degree of the integrated circuit device may increase. The target transistor herein may refer to a transistor that is intended to be (electrically) connected to the elements of the MOL structure.

An integrated circuit device, according to some embodiments, may include a substrate and a cell structure on an upper surface of the substrate. The cell structure may comprise a first transistor that comprises a first sidewall and a second sidewall that is opposite to the first sidewall in a first direction that is parallel with the upper surface of the substrate and a second transistor that comprises a third sidewall and a fourth sidewall that is opposite to the third sidewall in the first direction between the upper surface of the substrate and the first transistor in a second direction that is perpendicular to the upper surface of the substrate. One of the third sidewall and the fourth sidewall may overlap the first transistor in the second direction.

An integrated circuit device, according to some embodiments, may include a substrate, a first cell structure on an upper surface of the substrate, a second cell structure adjacent the first cell structure on the upper surface of the substrate, and a cell boundary between the first cell structure and the second cell structure in a first direction that is parallel with the upper surface of the substrate. Each of the first cell structure and the second cell structure may comprise a first transistor that comprises a first sidewall and a second sidewall that is opposite to the first sidewall in the first direction and a second transistor that comprises a third sidewall and a fourth sidewall that is opposite to the third sidewall in the first direction between the upper surface of the substrate and the first transistor in a second direction that is perpendicular to the upper surface of the substrate. One of the third sidewall and the fourth sidewall may overlap the first transistor in the second direction. Another one of the third sidewall and the fourth sidewall may be free of overlap with the first transistor in the second direction. The first cell structure and the second cell structure may be in a same configuration with respect to the cell boundary in the first direction.

An integrated circuit device, according to some embodiments, may include a substrate, a first cell structure on an upper surface of the substrate, a second cell structure adjacent the first cell structure on the upper surface of the substrate, and a cell boundary between the first cell structure and the second cell structure in a first direction that is parallel with the upper surface of the substrate. Each of the first cell structure and the second cell structure may comprise a first transistor that comprises a first sidewall and a second sidewall that is opposite to the first sidewall in the first direction and a second transistor that comprises a third sidewall and a fourth sidewall that is opposite to the third sidewall in the first direction between the upper surface of the substrate and the first transistor in a second direction that is perpendicular to the upper surface of the substrate. One of the third sidewall and the fourth sidewall may overlap the first transistor in the second direction. Another one of the third sidewall and the fourth sidewall may be free of overlap with the first transistor in the second direction. The first cell structure and the second cell structure may be mirror-image symmetrical to each other with respect to the cell boundary in the first direction.

### BRIEF DESCRIPTION OF THE DRAWINGS

FIGS. 1A and 1B are a plan view and a cross-sectional view of a cell structure in an integrated circuit device according to some embodiments, respectively.
FIGS. 2A and 2B are a plan view and a cross-sectional view of sequentially arranged cell structures in an integrated circuit device according to some embodiments, respectively.
FIGS. 3A and 3B are a plan view and a cross-sectional view of flipped cell structures in an integrated circuit device according to some embodiments, respectively.
FIGS. 4A and 4B are a plan view and a cross-sectional view of sequentially arranged cell structures with a shared conductive track in an integrated circuit device according to some embodiments, respectively.
FIGS. 5A and 5B are a plan view and a cross-sectional view of flipped cell structures with a shared conductive track in an integrated circuit device according to some embodiments, respectively.

### DETAILED DESCRIPTION OF EMBODIMENTS

Pursuant to embodiments herein, an integrated circuit device may include an upper transistor and a lower transistor in a Z-shape scheme. For example, the upper transistor and the lower transistor may be staggered with respect to each other in the horizontal direction. In some embodiments, the upper transistor and the lower transistor may be positioned in a zigzag arrangement in the horizontal direction.

Example embodiments will be described in greater detail with reference to the attached figures.

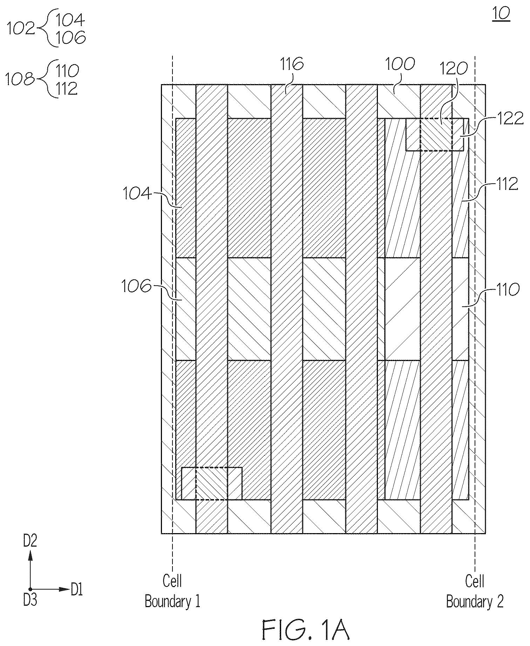

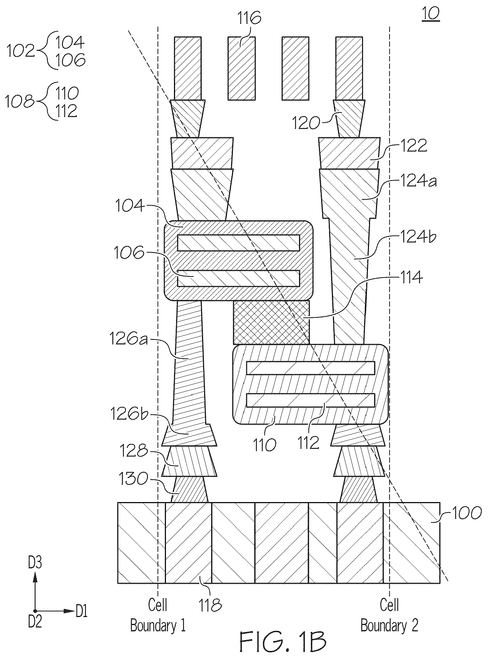

FIGS. 1A and 1B are a plan view and a cross-sectional view of a cell structure in an integrated circuit device 10 according to some embodiments, respectively. FIG. 1A may be a plan view from an upper side of the integrated circuit device 10. For example, FIG. 1A may be a bird's eye view of the top of the integrated circuit device 10. FIG. 1B may be a cross-sectional view (combined representation of different section planes parallel to directions D1 and D3) of the integrated circuit device 10 illustrated in FIG. 1A.

Referring to FIGS. 1A and 1B, the integrated circuit device 10 may include a first cell structure on a substrate 100. The integrated circuit device 10 may have a first cell boundary (e.g., cell boundary 1) and a second cell boundary (e.g., cell boundary 2) that is spaced apart from the first cell boundary in a horizontal direction that is parallel with an upper surface of the substrate 100. For example, the first cell boundary and the second cell boundary may be spaced apart from each other in a first direction D1 that is parallel with the upper surface of the substrate 100. The first cell structure may be between the first cell boundary and the second cell boundary in the first direction D1. The second cell boundary may be opposite to the first cell boundary with respect to the first cell structure in the first direction D1. For example, the first cell structure may refer to a region that includes various elements of the integrated circuit device 10 between the first cell boundary and the second cell boundary in the first direction D1.

The substrate 100 may include semiconductor material(s), for example, Si, Ge, SiGe, GaP, GaAs, SiC, SiGeC and/or InP and/or may include insulating material(s), for example, silicon oxide, silicon oxynitride, silicon nitride, silicon carbonitride and/or a low-k material. In some embodiments, the substrate may be a bulk substrate (e.g., a silicon wafer), a semiconductor on insulator (SOI) substrate or an insulating layer (e.g., a monolithic insulating layer). The low-k material may have a lower dielectric constant than that of silicon oxide (e.g., SiO). The low-k material may include, for example, fluorine-doped silicon oxide, organosilicate glass, carbon-doped oxide, porous silicon dioxide, porous organosilicate glass, spin-on organic polymeric dielectrics and/or spin-on silicon based polymeric dielectric.

Referring to FIGS. 1A and 1B, the first cell structure of the integrated circuit device 10 may include a first transistor 102 (e.g., an upper transistor 102) and a second transistor 108 (e.g., a lower transistor 108) formed on the substrate 100. The second transistor 108 may be between (the upper surface of) the substrate 100 and the first transistor 102 in a vertical direction that is perpendicular to the upper surface and/or a lower surface of the substrate 100. Herein, the vertical direction may refer to a third direction D3 in the drawings. In some embodiments, the first transistor 102 and the second transistor 108 may be staggered in the first direction D1. For example, the center (or a central portion) of the first transistor 102 and the center (or a central portion) of the second transistor 108 may not overlap (e.g., may be misaligned with) each other in the third direction D3. For example, the center (or the central portion) of the first transistor 102 and the center (or the central portion) of the second transistor 108 may be offset from each other in the first direction D1. In some embodiments, the first transistor 102 may have a first sidewall and a second sidewall that is opposite to the first sidewall in the first direction D1, and the second transistor 108 may have a third sidewall and a fourth sidewall that is opposite to the third sidewall in the first direction D1. The first sidewall and the second sidewall of the first transistor 102 and the third sidewall and the fourth sidewall of the second transistor 108 may not overlap with each other in the third direction D3. For example, a plane of the second sidewall of the first transistor 102 may be between respective planes of the third sidewall and the fourth sidewall of the second transistor 108 in the first direction D1. A plane of the first sidewall of the first transistor 102 may be free of overlap with respective planes of the third sidewall and the fourth sidewall of the second transistor 108 in the third direction D3. The first sidewall of the first transistor 102 may be free of overlap with the second transistor 108 in the third direction D3. For example, a plane of the third sidewall of the second transistor 108 may be between respective planes of the first sidewall and the second sidewall of the first transistor 102 in the first direction D1. For example, a plane of the third sidewall of the second transistor 108 may overlap the first transistor 102 in the third direction D3. A plane of the fourth sidewall of the second transistor 108 may be free of overlap with respective planes of the first sidewall and the second sidewall of the first transistor 102 in the third direction D3. The fourth sidewall of the second transistor 108 may be free of overlap with the first transistor 102 in the third direction D3. In summary, the first transistor 102 may have a portion that is free of overlap with the second transistor 108 in the third direction D3, and the second transistor 108 may have a portion that is free of overlap with the first transistor 102 in the third direction D3. However, the relative locations of the first transistor 102 and the second transistor 108 are not limited to the embodiments described above. The staggered (zigzag) structure of the first transistor 102 and the second transistor 108 may be referred to as a Z-shape scheme or a Z-shape 3D stacked device (e.g., Z-shape 3D stacked field effect transistor (Z-shape 3DSFET)).

The first transistor 102 and the second transistor 108 may have different conductivity types or the same conductivity type. In some embodiments, the first transistor 102 may include a first source/drain region 104. The first transistor 102 may be a P-type transistor, and the first source/drain region 104 may be a P-type source/drain region. The second transistor 108 may include a second source/drain region 110. The second transistor 108 may be an N-type transistor, and the second source/drain region 110 may be an N-type source/drain region. However, the inventive concepts of the types of the first transistor 102 and the second transistor 108 are not limited to the embodiments described above. For example, the first transistor 102 may be an N-type transistor including an N-type source/drain region (e.g., the first source/drain region 104), and the second transistor 108 may be a P-type transistor including a P-type source/drain region (e.g., the second source/drain region 110). The first transistor 102 and the second transistor 108 may be implemented using various types of transistors (e.g., a planar transistor, a gate-all-around field-effect transistor (GAA FET), a recessed channel array transistor (RCAT), a fin field-effect transistor (FinFET), or multi-bridge-channel field effect transistor (MBCFET^{™})). Hereinafter, the first transistor 102 and the second transistor 108 are described as MBCFETs^{™} for the convenience of the description, but the types of the first transistor 102 and the second transistor 108 are not limited thereto.

The first transistor 102 may comprise first channel layers 106 (e.g., upper channel layers 106) and a first work function layer (e.g., an upper work function layer) (not illustrated) on the first channel layers 106. The first transistor 102 may further comprise first gate insulators (e.g., upper gate insulators) (not illustrated) on the first channel layers 106, and a first gate electrode (e.g., an upper gate electrode) (not illustrated) on the first work function layer. For example, the first gate insulators may be between the first channel layers 106 and the first work function layer. The first gate insulators, the first work function layer, and the first gate electrode may be collectively referred to as a first gate structure (e.g., an upper gate structure).

The first channel layers 106 may be spaced apart from each other in the vertical direction (e.g., in the third direction D3). In some embodiments, the first channel layers 106 may be spaced apart from each other at equal or substantially equal distance in the vertical direction. In some embodiments, each of the first channel layers 106 may have an equal or a substantially equal width in the first direction D1 and a second direction D2 that is parallel with an upper surface of the substrate and intersects the first direction D1. The second direction D2 may be perpendicular to the first direction D1. Herein, "substantially" may mean no greater than a 10% deviation. For example, when element X has a width of 10nm and a width of element Y is substantially equal to that of element X, the width of element Y may not be less than 9nm or greater than 11nm.

The first gate insulators may extend around (e.g., at least partially surround) the first channel layers 106, respectively. The first work function layer may extend around (e.g., at least partially surround) the first gate insulators (and the first channel layers 106). The first gate electrode may extend around (e.g., at least partially surround) the first work function layer.

In some embodiments, the first channel layers 106 may include semiconductor material(s), for example, Si, Ge, SiGe, GaP, GaAs, SiC, SiGeC and/or InP. In some embodiments, the first gate insulators may include insulator(s), for example, silicon oxide, silicon oxynitride, silicon nitride, silicon carbonitride and/or a low-k material that has a lower dielectric constant than that of silicon oxide. In some embodiments, the first work function layer may include, for example, a TiN layer, a TaN layer, a TiAl layer, a TiC layer, a TiAlC layer, a TiAlN layer and/or a WN layer. In some embodiments, the first gate electrode may include, for example, tungsten (W), aluminum (Al) and/or copper (Cu). However, the materials of the first channel layers 106, the first gate insulators, the first work function layer, and the first gate electrode are not limited to the embodiments described above. In some embodiments, the first gate insulators and the first gate electrode may be omitted.

The second transistor 108 may comprise second channel layers 112 (e.g., lower channel layers 112) and a second work function layer (e.g., a lower work function layer) (not illustrated) on the second channel layers 112. The second transistor 108 may further comprise second gate insulators (e.g., lower gate insulators) (not illustrated) on the second channel layers 112, and a second gate electrode (e.g., a lower gate electrode) (not illustrated) on the second work function layer. For example, the second gate insulators may be between the second channel layers 112 and the second work function layer. The second gate insulators, the second work function layer, and the second gate electrode may be collectively referred to as a second gate structure (e.g., a lower gate structure).

The second channel layers 112 may be spaced apart from each other in the vertical direction (e.g., in the third direction D3). In some embodiments, the second channel layers 112 may be spaced apart from each other at equal or substantially equal distance in the vertical direction. In some embodiments, each of the second channel layers 112 may have an equal or a substantially equal width in the first direction D1 and/or the second direction D2. In some embodiments, the width of the first channel layers 106 in the first direction D1 may be (substantially) the same as the width of the second channel layers 112 in the first direction D1. In some embodiments, the width of the first channel layers 106 in the second direction D2 may be (substantially) the same as the width of the second channel layers 112 in the second direction D2. However, the relative widths of the first channel layers 106 and the second channel layers 112 in the first direction D1 and the second direction D2 are not limited thereto.

The second gate insulators may extend around (e.g., at least partially surround) the second channel layers 112, respectively. The second work function layer may extend around (e.g., at least partially surround) the second gate insulators. The second gate electrode may extend around (e.g., at least partially surround) the second work function layer.

In some embodiments, the second channel layers 112 may include semiconductor material(s), for example, Si, Ge, SiGe, GaP, GaAs, SiC, SiGeC and/or InP. In some embodiments, the second gate insulators may include insulator(s), for example, silicon oxide, silicon oxynitride, silicon nitride, silicon carbonitride and/or a low-k material that has a lower dielectric constant than that of silicon oxide. In some embodiments, the second work function layer may include, for example, a TiN layer, a TaN layer, a TiAl layer, a TiC layer, a TiAlC layer, a TiAlN layer and/or a WN layer. In some embodiments, the second gate electrode may include, for example, tungsten (W), aluminum (Al) and/or copper (Cu). However, the materials of the second channel layers 112, the second gate insulators, the second work function layer, and the second gate electrode are not limited to the embodiments described above. In some embodiments, the second gate insulators and the second gate electrode may be omitted.

In some embodiments, each of the first channel layers 106 and the second channel layers 112 may be a nanosheet (that may have a thickness in a range of from 1 nm to 100 nm in the vertical direction) or may be a nanowire (that may have a circular cross-section with a diameter in a range of from 1 nm to 100 nm). The number of the first channel layers 106 and the number of the second channel layers 112 may vary.

The integrated circuit device 10 may include an insulator 114 (also referred to as an inter-gate insulator 114 or a middle dielectric isolation 114) between the first transistor 102 and the second transistor 108 in the third direction D3. The insulator 114 may include insulator(s), for example, silicon nitride (e.g., SiN). However, the material of the insulator 114 is not limited thereto.

The integrated circuit device 10 may include front-side conductive tracks 116 on (the upper surface of) the first transistor 102. The front-side conductive tracks 116 may be spaced apart from each other in the first direction D1. Although not illustrated, an interlayer insulating layer may extend around (e.g., at least partially surround) the front-side conductive tracks 116. The front-side conductive tracks 116 may be spaced apart from each other by (substantially) the same distance in the first direction D1. In some embodiments, the front-side conductive tracks 116 may be spaced apart from each other by different distances in the first direction D1. In some embodiments, each of the front-side conductive tracks 116 may have the same or substantially the same width in the first direction D1. In some embodiments, one of the front-side conductive tracks 116 may have a width in the first direction D1 different from a width of another one of the front-side conductive tracks 116 in the first direction D1. In some embodiments, the distance between adjacent ones of the front-side conductive tracks 116 in the first direction D1 may be equal or substantially equal to the width of one of the front-side conductive tracks 116 in the first direction D1.

In some embodiments, the front-side conductive tracks 116 may be within the first cell structure. For example, the front-side conductive tracks 116 may be between the first cell boundary and the second cell boundary in the first direction D1. However, the embodiments of the front-side conductive tracks 116 are not limited thereto. For example, the front-side conductive tracks 116 may overlap the first cell boundary and/or the second cell boundary in the third direction D3. Although four (4) front-side conductive tracks 116 between the first cell boundary and the second cell boundary (in the first cell structure) are illustrated in FIGS. 1A and 1B, the number of the front-side conductive tracks 116 is not limited thereto. In some embodiments, the front-side conductive tracks 116 may include a conductive material, such as a metal. For example, the front-side conductive tracks 116 may include copper, aluminum, and/or tungsten, but not limited thereto. In some embodiments, the front-side conductive tracks 116 may be configured to function as signal transfer paths (tracks) and/or a front-side power delivery network (FSPDN) for the integrated circuit device 10. For example, the front-side conductive tracks 116 may be configured to transfer a signal to or from at least one of the first transistor 102 and the second transistor 108 through a conductive contact and/or a conductive via (which will be described in detail below). For example, the front-side conductive tracks 116 may be configured to supply power to at least one of the first transistor 102 and the second transistor 108 through a conductive contact and/or a conductive via (which will be described in detail below).

The integrated circuit device 10 may include back-side conductive tracks 118 on (below)/in the substrate 100. In some embodiments, the back-side conductive tracks 118 may be in the substrate 100. In some embodiments, the back-side conductive tracks 118 may be on a lower surface of the substrate 100. For example, the integrated circuit device 10 may include back-side conductive tracks 118 on (below) the second transistor 108. Although not illustrated, an interlayer insulating layer may extend around (e.g., at least partially surround) the back-side conductive tracks 118. The back-side conductive tracks 118 may be spaced apart from each other in the first direction D1. The back-side conductive tracks 118 may be spaced apart from each other by (substantially) the same distance in the first direction D1. In some embodiments, the back-side conductive tracks 118 may be spaced apart from each other by different distances in the first direction D1. In some embodiments, each of the back-side conductive tracks 118 may have the same or substantially the same width in the first direction D1. In some embodiments, one of the back-side conductive tracks 118 may have a width in the first direction D1 different from a width of another one of the back-side conductive tracks 118 in the first direction D1. In some embodiments, the distance between adjacent ones of the back-side conductive tracks 118 in the first direction D1 may be equal or substantially equal to the width of the back-side conductive track 118 in the first direction D1.

The back-side conductive tracks 118 may be within the first cell structure. For example, the back-side conductive tracks 118 may be between the first cell boundary and the second cell boundary in the first direction D1. However, the embodiments of the back-side conductive tracks 118 are not limited thereto. For example, the back-side conductive tracks 118 may overlap the first cell boundary and/or the second cell boundary in the third direction D3. Although three (3) back-side conductive tracks 118 between the first cell boundary and the second cell boundary (in the first cell structure) are illustrated in FIGS. 1A and 1B, the number of the back-side conductive tracks 118 is not limited thereto. For example, in the first cell structure, the number of the back-side conductive tracks 118 may be the same as the number of the front-side conductive tracks 116. In some embodiments, the back-side conductive tracks 118 may include a conductive material, such as a metal. For example, the back-side conductive tracks 118 may include copper, aluminum, and/or tungsten, but not limited thereto. In some embodiments, the back-side conductive tracks 118 may be configured to perform as signal transfer paths (tracks) and/or a back-side power delivery network (BSPDN) for the integrated circuit device 10. For example, the back-side conductive tracks 118 may be configured to transfer a signal to or from at least one of the first transistor 102 and the second transistor 108 through a conductive contact and/or a conductive via (which will be described in detail below). For example, the back-side conductive tracks 118 may be configured to supply power to at least one of the first transistor 102 and the second transistor 108 through a conductive contact and/or a conductive via (which will be described in detail below).

The integrated circuit device 10 may further include a middle-of-line (MOL) structure. The MOL structure may include interlayer insulating layer(s) in which conductive wire(s) (e.g., metal wire(s)), conductive via(s) (e.g., metal via(s)), and/or conductive contact(s) (e.g., metal contact(s)) are provided. Various elements of the first transistor 102 and the second transistor 108 may be (electrically) connected to the MOL structure. In some embodiments, the front-side conductive tracks 116 and/or the back-side conductive tracks 118 may be electrically connected to the first transistor 102 and/or the second transistor 108 through the MOL structure.

Referring to FIGS. 1A and 1B, for example, the MOL structure may include front-side conductive vias 120, a front-side upper conductive contact 122, a front-side middle conductive contact 124a, a front-side lower conductive contact 124b, a back-side upper conductive contact 126a, a back-side middle conductive contact 126b, a back-side lower conductive contact 128, and back-side conductive vias 130. However, the MOL structure is not limited to the embodiments described above. For example, the MOL structure may include an additional element that is not described above, or some of the elements of the MOL structure described above may be omitted or integrated with each other.

In some embodiments, the front-side conductive vias 120 may be between the front-side conductive tracks 116 and a transistor (e.g., the first transistor 102 and/or the second transistor 108) in the third direction D3. The front-side upper conductive contact 122 may be between (corresponding) one of the front-side conductive vias 120 and a transistor (e.g., the first transistor 102 and/or the second transistor 108) in the third direction D3. The front-side middle conductive contact 124a may be between the front-side upper conductive contact 122 and a transistor (e.g., the first transistor 102 and/or the second transistor 108) in the third direction D3. The front-side lower conductive contact 124b may be between the front-side middle conductive contact 124a and a transistor (e.g., the first transistor 102 and/or the second transistor 108) in the third direction D3. In some embodiments, the front-side middle conductive contact 124a may be in contact with the first transistor 102. In some embodiments, the front-side lower conductive contact 124b may be in contact with the second transistor 108. However, the configuration of the MOL structure among the first transistor 102, the second transistor 108, the front-side conductive tracks 116, and the back-side conductive tracks 118 is not limited to the embodiments described above.

In some embodiments, the back-side upper conductive contact 126a may be between the back-side conductive tracks 118 and a transistor (e.g., the first transistor 102 and/or the second transistor 108) in the third direction D3. The back-side middle conductive contact 126b may be between the back-side upper conductive contact 126a and the back-side conductive tracks 118 in the third direction D3. The back-side lower conductive contact 128 may be between the back-side middle conductive contact 126b and the back-side conductive tracks 118 in the third direction D3. The back-side conductive vias 130 may be between the back-side lower conductive contact 128 and the back-side conductive tracks 118 in the third direction D3. However, the configuration of the MOL structure among the first transistor 102, the second transistor 108, the front-side conductive tracks 116, and the back-side conductive tracks 118 is not limited to the embodiments described above.

The elements of the MOL structure in the Z-shape scheme may not overlap the target transistor (e.g., the first transistor 102 or the second transistor 108) in a horizontal direction (e.g., in the first direction D1 or the second direction D2). The target transistor herein may refer to a transistor that is intended to be (electrically) connected to the elements of the MOL structure. Referring to FIG. 1B, for example, the front-side conductive via 120, the front-side upper conductive contact 122, and the front-side middle conductive contact 124a (electrically) connected to the first transistor 102 may not overlap the first transistor 102 in the first direction D1 or the second direction D2. Referring to FIG. 1B, for example, the front-side conductive via 120, the front-side upper conductive contact 122, the front-side middle conductive contact 124a, and the front-side lower conductive contact 124b (electrically) connected to the second transistor 108 may not overlap the second transistor 108 in the first direction D1 or the second direction D2. Referring to FIG. 1B, for example, the back-side upper conductive contact 126a, the back-side middle conductive contact 126b, the back-side lower conductive contact 128, and the back-side conductive via 130 (electrically) connected to the first transistor 102 may not overlap the first transistor 102 in the first direction D1 or the second direction D2. Referring to FIG. 1B, for example, the back-side middle conductive contact 126b, the back-side lower conductive contact 128, and the back-side conductive via 130 (electrically) connected to the second transistor 108 may not overlap the second transistor 108 in the first direction D1 or the second direction D2. The (electrical) connection between elements of the MOL structure and the target transistor without a detour in a space between the target transistor (e.g., the sidewall of the target transistor facing the adjacent cell boundary) and the adjacent cell boundary may be referred to as a direct contact scheme.

Referring to FIGS. 1A and 1B, the elements of the first cell structure between the front-side conductive tracks 116 and the back-side conductive tracks 118 in the third direction D3 may be (substantially) symmetrical (e.g., may comprise a flipped configuration) with respect to a diagonal direction (e.g., a dashed diagonal line illustrated in FIG. 1B) of the first direction D1 and the second direction D2. For example, the first transistor 102, the front-side conductive via 120, the front-side upper conductive contact 122, the front-side middle conductive contact 124a, and the front-side lower conductive contact 124b may correspond to the second transistor 108, the back-side conductive via 130, the back-side lower conductive contact 128, the back-side middle conductive contact 126b, and the back-side upper conductive contact 126a, respectively. For example, the first transistor 102, the front-side conductive via 120, the front-side upper conductive contact 122, the front-side middle conductive contact 124a, and the front-side lower conductive contact 124b may be (substantially) symmetrical (e.g., a mirror-image) to the second transistor 108, the back-side conductive via 130, the back-side lower conductive contact 128, the back-side middle conductive contact 126b, and the back-side upper conductive contact 126a, respectively, with respect to a diagonal direction of the first direction D1 and the second direction D2.

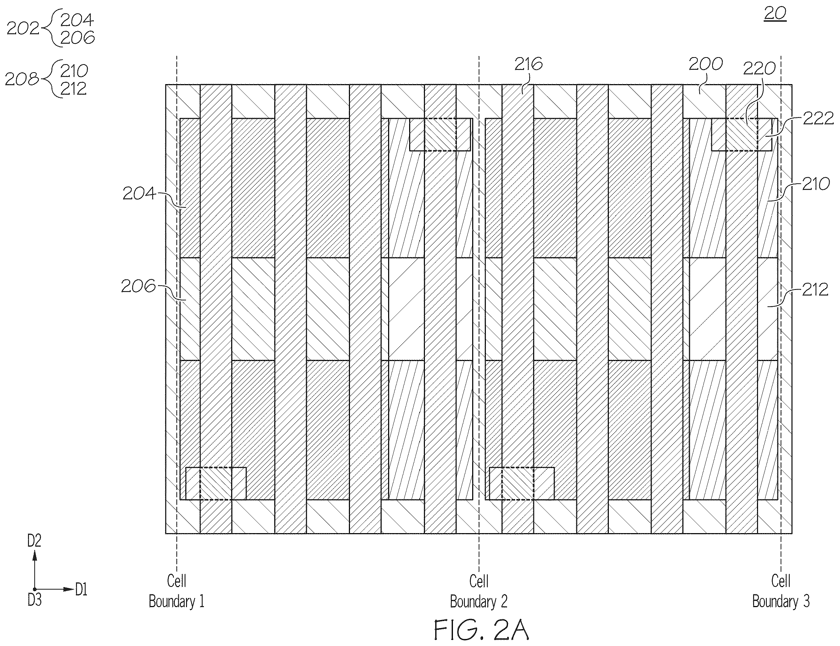

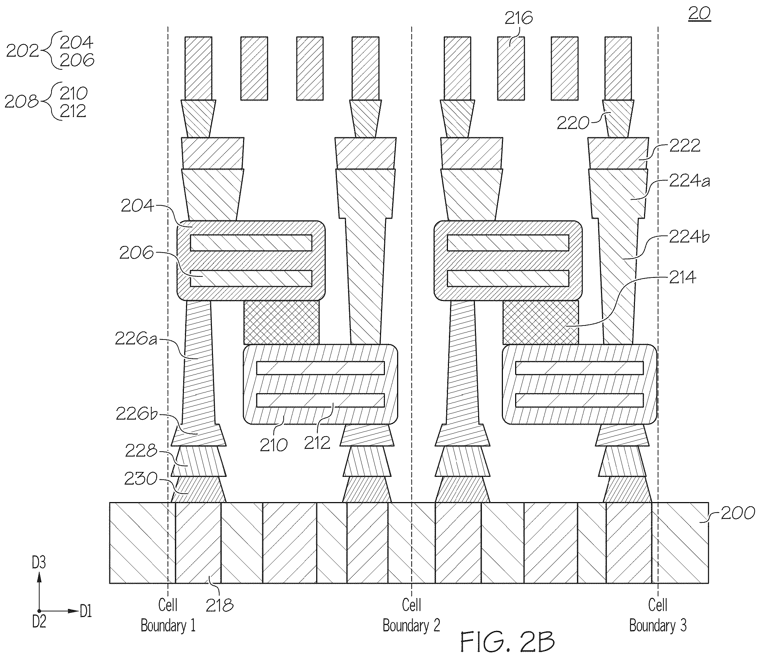

FIGS. 2A and 2B are a plan view and a cross-sectional view of sequentially arranged cell structures in an integrated circuit device 20 according to some embodiments, respectively. FIG. 2A may be a plan view from an upper side of the integrated circuit device 20. For example, FIG. 2A may be a bird's eye view of the top of the integrated circuit device 20. FIG. 2B may be a cross-sectional view (combined representation of different section planes parallel to directions D1 and D3) of the integrated circuit device 20 illustrated in FIG. 2A.

Since the integrated circuit device 20 may be (at least partially) formed and configured similarly as the integrated circuit device 10 in FIGS. 1A and 1B, detailed descriptions of the common configuration with the integrated circuit device 10 may be omitted, and differences from the integrated circuit device 10 will be described in detail. The substrate 200, the first transistor 202, the first source/drain region 204, the first channel layers 206, the second transistor 208, the second source/drain region 210, the second channel layers 212, the insulator 214, the front-side conductive tracks 216, the back-side conductive tracks 218, the front-side conductive vias 220, the front-side upper conductive contact 222, the front-side middle conductive contact 224a, the front-side lower conductive contact 224b, the back-side upper conductive contact 226a, the back-side middle conductive contact 226b, the back-side lower conductive contact 228, and the back-side conductive vias 230 in FIGS. 2A and 2B may correspond to the substrate 100, the first transistor 102, the first source/drain region 104, the first channel layers 106, the second transistor 108, the second source/drain region 110, the second channel layers 112, the insulator 114, the front-side conductive tracks 116, the back-side conductive tracks 118, the front-side conductive vias 120, the front-side upper conductive contact 122, the front-side middle conductive contact 124a, the front-side lower conductive contact 124b, the back-side upper conductive contact 126a, the back-side middle conductive contact 126b, the back-side lower conductive contact 128, and the back-side conductive vias 130 in FIGS. 1A and 1B, respectively.

The integrated circuit device 20 may include a second cell structure on the substrate 200. The second cell structure may be adjacent the first cell structure in the horizontal direction (e.g., in the first direction D1). The integrated circuit device 20 may further have a third cell boundary (e.g., cell boundary 3) that is spaced apart from the second cell boundary (e.g., cell boundary 2) in the horizontal direction (e.g., the first direction D1). For example, the second cell boundary (e.g., cell boundary 2) may be between the first cell boundary (e.g., cell boundary 1) and the third cell boundary (e.g., cell boundary 3) in the first direction D1. The second cell structure may be between the second cell boundary and the third cell boundary in the first direction D1. The third cell boundary may be opposite to the second cell boundary with respect to the second cell structure in the first direction D1. For example, the second cell structure may refer to a region that includes various elements of the integrated circuit device 20 between the second cell boundary and the third cell boundary in the first direction D1.

The second cell structure that is adjacent the first cell structure in a horizontal direction (e.g., the first direction D1) may comprise (substantially) the same elements of the first cell structure described above. In some embodiments, the configurations, structures, and shapes of the elements of the second cell structure may be (substantially) the same as those of the first cell structure. However, the embodiments of the configurations, structures, and shapes of the second cell structure and the elements therein are not limited thereto. For example, some of the elements of the first cell structure described above may be modified or omitted in the second cell structure.

Referring to FIGS. 2A and 2B, the MOL structure may not be positioned in the area between the second transistor 208 of the first cell structure and the first transistor 202 of the second cell structure in the first direction D1. Although not illustrated, the MOL structure may not be positioned in the area between the first transistor 202 of the first cell structure and the second transistor 208 of the second cell structure in the first direction D1. For example, the MOL structure may not overlap the second cell boundary in the third direction D3.

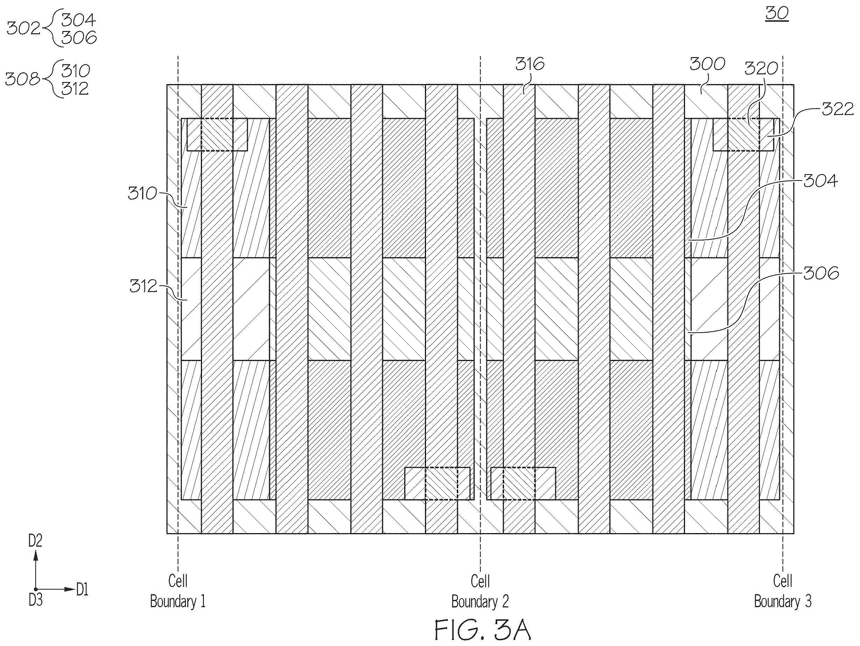

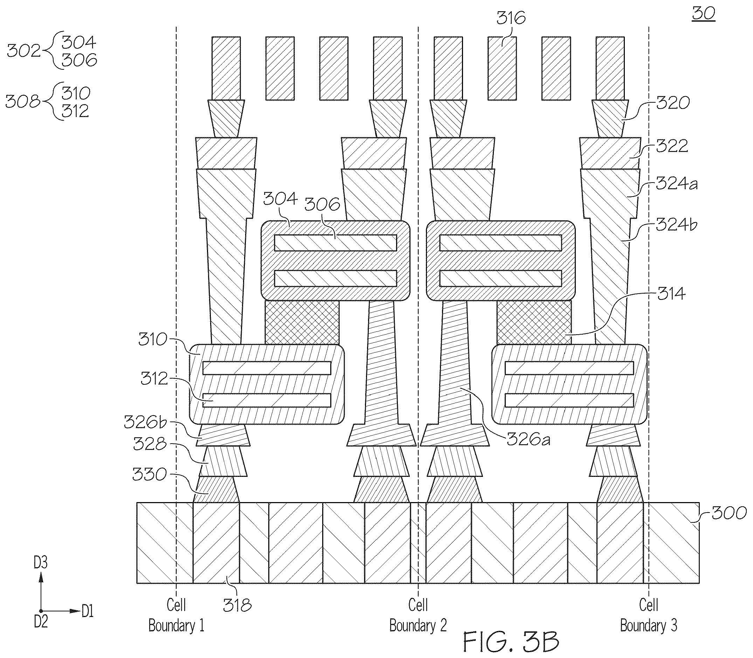

FIGS. 3A and 3B area plan view and a cross-sectional view of flipped cell structures in an integrated circuit device 30 according to some embodiments, respectively. FIG. 3A may be a plan view from an upper side of the integrated circuit device 30. For example, FIG. 3A may be a bird's eye view of the top of the integrated circuit device 30. FIG. 3B may be a cross-sectional view (combined representation of different section planes parallel to directions D1 and D3) of the integrated circuit device 30 illustrated in FIG. 3A.

Since the integrated circuit device 30 may be (at least partially) formed and configured similarly as the integrated circuit device 20 in FIGS. 2A and 2B, detailed descriptions of the common configuration with the integrated circuit device 20 may be omitted, and differences from the integrated circuit device 20 will be described in detail. The substrate 300, the first transistor 302, the first source/drain region 304, the first channel layers 306, the second transistor 308, the second source/drain region 310, the second channel layers 312, the insulator 314, the front-side conductive tracks 316, the back-side conductive tracks 318, the front-side conductive vias 320, the front-side upper conductive contact 322, the front-side middle conductive contact 324a, the front-side lower conductive contact 324b, the back-side upper conductive contact 326a, the back-side middle conductive contact 326b, the back-side lower conductive contact 328, and the back-side conductive vias 330 in FIGS. 3A and 3B may correspond to the substrate 200, the first transistor 202, the first source/drain region 204, the first channel layers 206, the second transistor 208, the second source/drain region 210, the second channel layers 212, the insulator 214, the front-side conductive tracks 216, the back-side conductive tracks 218, the front-side conductive vias 220, the front-side upper conductive contact 222, the front-side middle conductive contact 224a, the front-side lower conductive contact 224b, the back-side upper conductive contact 226a, the back-side middle conductive contact 226b, the back-side lower conductive contact 228, and the back-side conductive vias 230 in FIGS. 2A and 2B, respectively.

The second cell structure that is adjacent the first cell structure in a horizontal direction (e.g., the first direction D1) may comprise (substantially) the same elements of the first cell structure described above. In some embodiments, the configurations, structures, and shapes of (the elements of) the first cell structure and (the corresponding elements of) the second cell structure may be (substantially) symmetrical to each other with respect to the second cell boundary in the first direction D1. For example, (the elements of) the first cell structure and (the corresponding elements of) the second cell structure may comprise a mirror-image with respect to the second cell boundary in the first direction D1 (respectively). However, the embodiments of the configurations, structures, and shape of the second cell structure and the elements therein are not limited thereto. For example, some of the elements of the first cell structure described above may be modified or omitted in the second cell structure.

Referring to FIGS. 3A and 3B, the MOL structure may not be positioned in the area between the first transistor 302 of the first cell structure and the first transistor 302 of the second cell structure in the first direction D1. Although not illustrated, the MOL structure may not be positioned in the area between the second transistor 308 of the first cell structure and the second transistor 308 of the second cell structure in the first direction D1. For example, the MOL structure may not overlap the second cell boundary in the third direction D3.

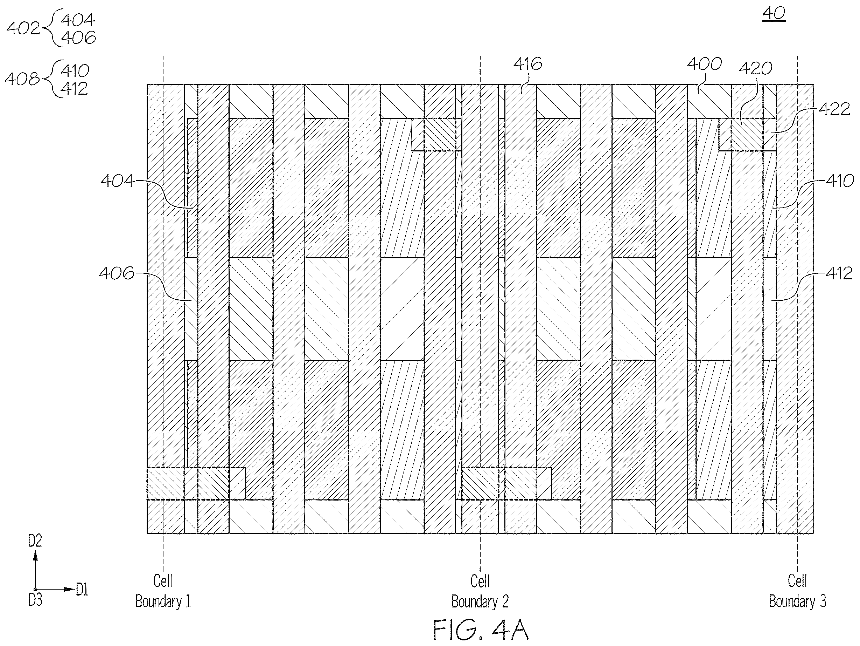

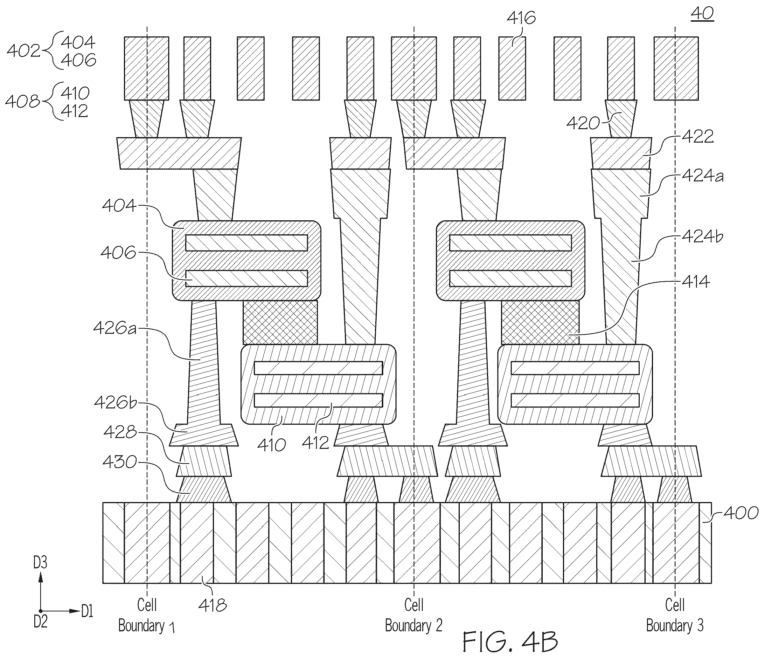

FIGS. 4A and 4B are a plan view and a cross-sectional view of sequentially arranged cell structures with a shared conductive track in an integrated circuit device 40 according to some embodiments, respectively. FIG. 4A may be a plan view from an upper side of the integrated circuit device 40. For example, FIG. 4A may be a bird's eye view of the top of the integrated circuit device 40. FIG. 4B may be a cross-sectional view (combined representation of different section planes parallel to directions D1 and D3) of the integrated circuit device 40 illustrated in FIG. 4A.

Since the integrated circuit device 40 may be (at least partially) formed and configured similarly as the integrated circuit device 20 in FIGS. 2A and 2B, detailed descriptions of the common configuration with the integrated circuit device 20 may be omitted, and differences from the integrated circuit device 20 will be described in detail. The substrate 400, the first transistor 402, the first source/drain region 404, the first channel layers 406, the second transistor 408, the second source/drain region 410, the second channel layers 412, the insulator 414, the front-side conductive tracks 416, the back-side conductive tracks 418, the front-side conductive vias 420, the front-side upper conductive contact 422, the front-side middle conductive contact 424a, the front-side lower conductive contact 424b, the back-side upper conductive contact 426a, the back-side middle conductive contact 426b, the back-side lower conductive contact 428, and the back-side conductive vias 430 in FIGS. 4A and 4B may correspond to the substrate 200, the first transistor 202, the first source/drain region 204, the first channel layers 206, the second transistor 208, the second source/drain region 210, the second channel layers 212, the insulator 214, the front-side conductive tracks 216, the back-side conductive tracks 218, the front-side conductive vias 220, the front-side upper conductive contact 222, the front-side middle conductive contact 224a, the front-side lower conductive contact 224b, the back-side upper conductive contact 226a, the back-side middle conductive contact 226b, the back-side lower conductive contact 228, and the back-side conductive vias 230 in FIGS. 2A and 2B, respectively.

Referring to FIGS. 4A and 4B, at least one of the front-side conductive tracks 416 may overlap a cell boundary (e.g., the first cell boundary, the second cell boundary, and/or the third cell boundary) in the third direction D3. In some embodiments, at least one of the front-side conductive vias 420 and/or at least one of the front-side upper conductive contacts 422 electrically connected to the at least one of the front-side conductive tracks 416 may overlap the cell boundary (e.g., the first cell boundary, the second cell boundary, and/or the third cell boundary) in the third direction D3. For example, the at least one of the front-side conductive vias 420 and the at least one of the front-side upper conductive contacts 422 may cross the cell boundary (e.g., the first cell boundary, the second cell boundary, and/or the third cell boundary). However, the embodiments of the configuration of the elements of the MOL structure are not limited to the descriptions above. For example, the front-side middle conductive contacts 424a and/or the front-side lower conductive contacts 424b may cross the cell boundary (e.g., the first cell boundary, the second cell boundary, and/or the third cell boundary). In some embodiments, elements of the MOL structure (e.g., the front-side conductive vias 420, the front-side upper conductive contacts 422, the front-side middle conductive contacts 424a, and the front-side lower conductive contacts 424b) may not overlap the target transistor in the first direction D1 and the second direction D2.

Referring to FIGS. 4A and 4B, at least one of the back-side conductive tracks 418 may overlap a cell boundary (e.g., the first cell boundary, the second cell boundary, and/or the third cell boundary) in the third direction D3. In some embodiments, at least one of the back-side conductive vias 430 and/or at least one of the back-side lower conductive contacts 428 electrically connected to the at least one of the back-side conductive tracks 418 may overlap the cell boundary (e.g., the first cell boundary, the second cell boundary, and/or the third cell boundary) in the third direction D3. For example, the at least one of the back-side conductive vias 430 and the at least one of the back-side lower conductive contacts 428 may cross the cell boundary (e.g., the first cell boundary, the second cell boundary, and/or the third cell boundary). However, the embodiments of the configuration of the elements of the MOL structure are not limited to the descriptions above. For example, the back-side middle conductive contacts 426b and/or the back-side upper conductive contacts 426a may cross the cell boundary (e.g., the first cell boundary, the second cell boundary, and/or the third cell boundary). In some embodiments, elements of the MOL structure (e.g., the back-side conductive vias 430, the back-side lower conductive contacts 428, the back-side middle conductive contacts 426b, and the back-side upper conductive contacts 426a) may not overlap the target transistor in the first direction D1 and the second direction D2.

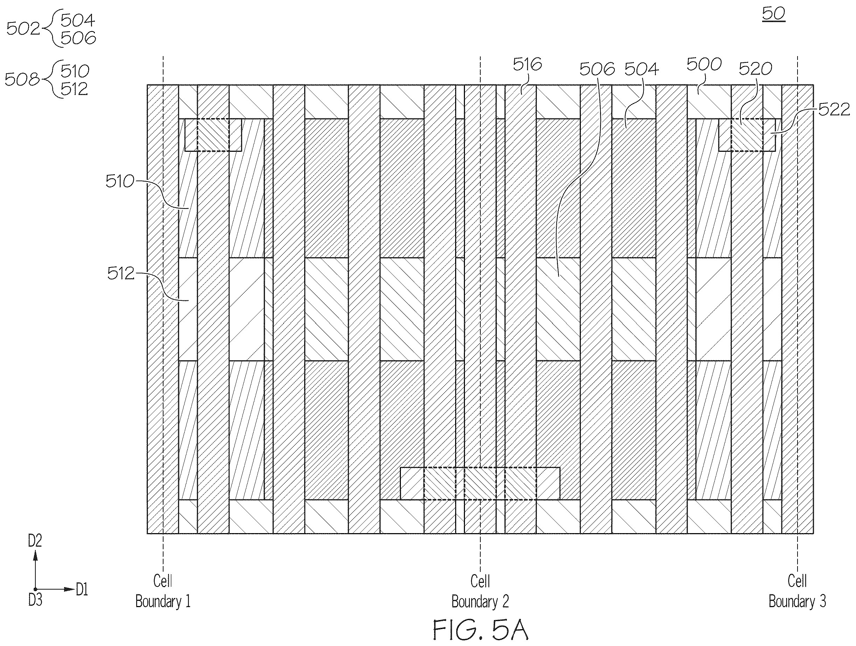

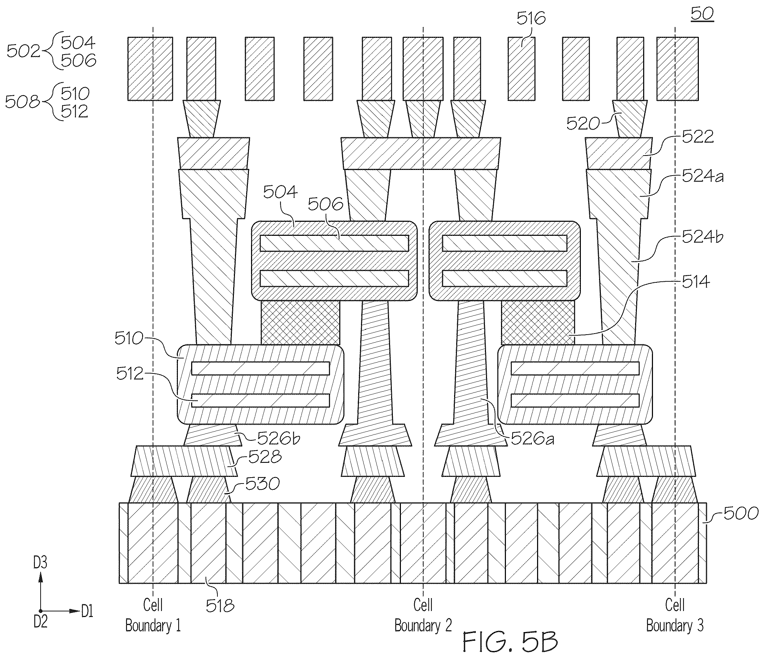

FIGS. 5A and 5B are a plan view and a cross-sectional view of flipped cell structures with a shared conductive track in an integrated circuit device 50 according to some embodiments, respectively. FIG. 5A may be a plan view from an upper side of the integrated circuit device 50. For example, FIG. 5A may be a bird's eye view of the top of the integrated circuit device 50. FIG. 5B may be a cross-sectional view (combined representation of different section planes parallel to directions D1 and D3) of the integrated circuit device 50 illustrated in FIG. 5A.

Since the integrated circuit device 50 may be (at least partially) formed and configured similarly as the integrated circuit device 30 in FIGS. 3A and 3B, detailed descriptions of the common configuration with the integrated circuit device 30 may be omitted, and differences from the integrated circuit device 30 will be described in detail. The substrate 500, the first transistor 502, the first source/drain region 504, the first channel layers 506, the second transistor 508, the second source/drain region 510, the second channel layers 512, the insulator 514, the front-side conductive tracks 516, the back-side conductive tracks 518, the front-side conductive vias 520, the front-side upper conductive contact 522, the front-side middle conductive contact 524a, the front-side lower conductive contact 524b, the back-side upper conductive contact 526a, the back-side middle conductive contact 526b, the back-side lower conductive contact 528, and the back-side conductive vias 530 in FIGS. 5A and 5B may correspond to the substrate 300, the first transistor 302, the first source/drain region 304, the first channel layers 306, the second transistor 308, the second source/drain region 310, the second channel layers 312, the insulator 314, the front-side conductive tracks 316, the back-side conductive tracks 318, the front-side conductive vias 320, the front-side upper conductive contact 322, the front-side middle conductive contact 324a, the front-side lower conductive contact 324b, the back-side upper conductive contact 326a, the back-side middle conductive contact 326b, the back-side lower conductive contact 328, and the back-side conductive vias 330 in FIGS. 3A and 3B, respectively.

Referring to FIGS. 5A and 5B, at least one of the front-side conductive tracks 516 may overlap a cell boundary (e.g., the first cell boundary, the second cell boundary, and/or the third cell boundary) in the third direction D3. In some embodiments, at least one of the front-side conductive vias 520 and/or at least one of the front-side upper conductive contacts 522 electrically connected to the at least one of the front-side conductive tracks 516 may overlap the cell boundary (e.g., the first cell boundary, the second cell boundary, and/or the third cell boundary) in the third direction D3. For example, the at least one of the front-side conductive vias 520 and the at least one of the front-side upper conductive contacts 522 may cross the cell boundary (e.g., the first cell boundary, the second cell boundary, and/or the third cell boundary). However, the embodiments of the configuration of the elements of the MOL structure are not limited to the descriptions above. For example, the front-side middle conductive contacts 524a and/or the front-side lower conductive contacts 524b may cross the cell boundary (e.g., the first cell boundary, the second cell boundary, and/or the third cell boundary). In some embodiments, elements of the MOL structure (e.g., the front-side conductive vias 520, the front-side upper conductive contacts 522, the front-side middle conductive contacts 524a, and the front-side lower conductive contacts 524b) may not overlap the target transistor in the first direction D1 and the second direction D2.

Referring to FIGS. 5A and 5B, at least one of the back-side conductive tracks 518 may overlap a cell boundary (e.g., the first cell boundary, the second cell boundary, and/or the third cell boundary) in the third direction D3. In some embodiments, at least one of the back-side conductive vias 530 and/or at least one of the back-side lower conductive contacts 528 electrically connected to the at least one of the back-side conductive tracks 518 may overlap the cell boundary (e.g., the first cell boundary, the second cell boundary, and/or the third cell boundary) in the third direction D3. For example, the at least one of the back-side conductive vias 530 and the at least one of the back-side lower conductive contacts 528 may cross the cell boundary (e.g., the first cell boundary, the second cell boundary, and/or the third cell boundary). However, the embodiments of the configuration of the elements of the MOL structure are not limited to the descriptions above. For example, the back-side middle conductive contacts 526b and/or the back-side upper conductive contacts 526a may cross the cell boundary (e.g., the first cell boundary, the second cell boundary, and/or the third cell boundary). In some embodiments, elements of the MOL structure (e.g., the back-side conductive vias 530, the back-side lower conductive contacts 528, the back-side middle conductive contacts 526b, and the back-side upper conductive contacts 526a) may not overlap the target transistor in the first direction D1 and the second direction D2.

Example embodiments described herein may provide various benefits for the integrated circuit device. For example, since the MOL structure is not located in the area adjacent the cell boundary (e.g., the area between the target transistor and the adjacent cell boundary in a horizontal direction), the Z-shape scheme may provide design flexibility and performance improvement for the integrated circuit device. The area adjacent the cell boundary (e.g., the area between the target transistor and the adjacent cell boundary in a horizontal direction) may be reduced (e.g., removed) to reduce the transistor width (e.g., cell height) in a horizontal direction to increase the integration degree of the integrated circuit device. In some embodiments, the transistor (e.g., the upper transistor and/or the lower transistor) may extend further into the area adjacent the cell boundary (e.g., the area between the target transistor and the adjacent cell boundary in a horizontal direction) to increase the (effective) channel width (Weff). In some embodiments, the increased channel width may provide room for reducing the height of the integrated circuit device (e.g., the height of the transistor) in the vertical direction without performance degradation. The reduced height of the integrated circuit device may reduce the complexities of the manufacturing processes by, for example, lowering the aspect ratio of the patterning. Also, multiple cell structures, each comprising the upper transistor and the lower transistor, may be arranged to be horizontally adjacent to each other regardless of the directions of the cell structures. For example, a first cell structure and a second cell structure that is adjacent the first cell structure may have the same configuration or may comprise a mirror-image in a cross-sectional view. However, it will be understood that the embodiments, goals, and benefits of the present disclosure are not limited to the descriptions above.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present inventive concepts to those skilled in the art. In the drawings, the sizes and relative sizes of layers and regions may be exaggerated for clarity. Like reference numbers may refer to like elements throughout unless clearly stated otherwise.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a", "an", and "the" are intended to include the plural forms as well, unless the context clearly indicates otherwise. It will be further understood that the terms "comprises", "comprising", "includes", and/or "including", when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled", "connected", or "responsive" to, or "on", another element, it can be directly coupled, connected, or responsive to, or on, the other element, or intervening elements may also be present. In contrast, when an element is referred to as being "directly coupled", "directly connected", or "directly responsive" to, or "directly on", another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or".

As used herein, "an element A overlapping an element B in a direction X" (or similar language) means that there is at least one line that extends in the direction X and intersects both the elements A and B.

It will be understood that although the terms "first", "second", etc. may be used herein to describe various elements, these elements should not be limited by these terms. These terms are only used to distinguish one element from another. Thus, a first element could be termed a second element without departing from the teachings of the present embodiments.

Many different embodiments have been disclosed herein, in connection with the above description and the drawings. It will be understood that it would be unduly repetitious and obfuscating to literally describe and illustrate every combination and sub-combination of these embodiments. Accordingly, the present specification, including the drawings, shall be construed to constitute a complete written description of all combinations and sub-combinations of the embodiments described herein, and of the manner and process of making and using them, and shall support claims to any such combination or sub-combination.

## Claims

1. An integrated circuit device comprising:
a substrate (100; 200; 300; 400; 500); and
at least one cell structure on an upper surface of the substrate (100; 200; 300; 400; 500),
wherein each of the at least one cell structure comprises:
a first transistor (102; 202; 302; 402; 502) that comprises a first sidewall and a second sidewall that is opposite to the first sidewall in a first direction (D1) that is parallel with the upper surface of the substrate (100; 200; 300; 400; 500);
a second transistor (108; 208; 308; 408; 508) that comprises a third sidewall and a fourth sidewall that is opposite to the third sidewall in the first direction (D1) between the upper surface of the substrate (100; 200; 300; 400; 500) and the first transistor (102; 202; 302; 402; 502) in a second direction (D3) that is perpendicular to the upper surface of the substrate (100; 200; 300; 400; 500);
a front-side conductive track (116; 216; 316; 416; 516) on an upper surface of the first transistor (102; 202; 302; 402; 502); and
a back-side conductive track (118; 218; 318; 418; 518) on a lower surface of the second transistor (108; 208; 308; 408; 508),
wherein one of the third sidewall and the fourth sidewall overlaps the first transistor (102; 202; 302; 402; 502) in the second direction (D3).

2. The integrated circuit device of Claim 1, wherein another one of the third sidewall and the fourth sidewall is free of overlap with the first transistor (102; 202; 302; 402; 502) in the second direction (D3).

3. The integrated circuit device of Claim 1 or 2, further comprising:
a front-side conductive contact (122, 124a, 124b) between the front-side conductive track (116; 216; 316; 416; 516) and at least one of the first transistor (102; 202; 302; 402; 502) and the second transistor (108; 208; 308; 408; 508) in the second direction (D3),
wherein the front-side conductive track (116; 216; 316; 416; 516) is electrically connected to the at least one of the first transistor (102; 202; 302; 402; 502) and the second transistor (108; 208; 308; 408; 508) through the front-side conductive contact (122, 124a, 124b).

4. The integrated circuit device of Claim 3, wherein the front-side conductive contact is free of overlap with the at least one of the first transistor (102; 202; 302; 402; 502) and the second transistor (108; 208; 308; 408; 508) in the first direction (D1).

5. The integrated circuit device of Claim 4, wherein the front-side conductive track (116; 216; 316; 416; 516) is configured to supply power to the at least one of the first transistor (102; 202; 302; 402; 502) and the second transistor (108; 208; 308; 408; 508) through the front-side conductive contact.

6. The integrated circuit device of Claim 4, wherein the front-side conductive track (116; 216; 316; 416; 516) is configured to transfer a signal to or from the at least one of the first transistor (102; 202; 302; 402; 502) and the second transistor (108; 208; 308; 408; 508) through the front-side conductive contact.

7. The integrated circuit device of any one of Claims 3 to 6, further comprising:
a back-side conductive contact between the back-side conductive track (118; 218; 318; 418; 518) and the at least one of the first transistor (102; 202; 302; 402; 502) and the second transistor (108; 208; 308; 408; 508) in the second direction (D3),
wherein the back-side conductive track (118; 218; 318; 418; 518) is electrically connected to the at least one of the first transistor (102; 202; 302; 402; 502) and the second transistor (108; 208; 308; 408; 508) through the back-side conductive contact.

8. The integrated circuit device of Claim 7, wherein the back-side conductive contact is free of overlap with the at least one of the first transistor (102; 202; 302; 402; 502) and the second transistor (108; 208; 308; 408; 508) in the first direction (D1).

9. The integrated circuit device of Claim 8, wherein the back-side conductive track (118; 218; 318; 418; 518) is configured to supply power to the at least one of the first transistor (102; 202; 302; 402; 502) and the second transistor (108; 208; 308; 408; 508) through the back-side conductive contact.

10. The integrated circuit device of Claim 8, wherein the back-side conductive track (118; 218; 318; 418; 518) is configured to transfer a signal to or from the at least one of the first transistor (102; 202; 302; 402; 502) and the second transistor (108; 208; 308; 408; 508) through the back-side conductive contact.

11. The integrated circuit device of claim 1 or 2, wherein:
the at least one cell structure comprises:
a first cell structure on the upper surface of the substrate (100; 200; 300; 400; 500); and
a second cell structure adjacent to the first cell structure on the upper surface of the substrate (100; 200; 300; 400; 500),
wherein the integrated circuit device further comprises a cell boundary between the first cell structure and the second cell structure in the first direction (D1), and
wherein the first and second transistors (102, 108; 202, 208; 302, 308; 402, 408; 502, 508) of the first cell structure and the second cell structure are arranged in a same configuration with respect to the cell boundary in the first direction (D1).

12. The integrated circuit device of Claim 11, further comprising:
a front-side conductive track (116; 216; 316; 416; 516) on an upper surface of the first transistor (102; 202; 302; 402; 502); and
a front-side conductive contact between the front-side conductive track (116; 216; 316; 416; 516) and at least one of the first transistor (102; 202; 302; 402; 502) and the second transistor (108; 208; 308; 408; 508) in the second direction (D3),
wherein the front-side conductive track (116; 216; 316; 416; 516) is electrically connected to the at least one of the first transistor (102; 202; 302; 402; 502) and the second transistor (108; 208; 308; 408; 508) through the front-side conductive contact.

13. The integrated circuit device of Claim 12, further comprising:
a back-side conductive track (118; 218; 318; 418; 518) on a lower surface of the second transistor (108; 208; 308; 408; 508); and
a back-side conductive contact between the back-side conductive track (118; 218; 318; 418; 518) and the at least one of the first transistor (102; 202; 302; 402; 502) and the second transistor (108; 208; 308; 408; 508) in the second direction (D3),
wherein the back-side conductive track (118; 218; 318; 418; 518) is electrically connected to the at least one of the first transistor (102; 202; 302; 402; 502) and the second transistor (108; 208; 308; 408; 508) through the back-side conductive contact.

14. The integrated circuit device of Claim 13, wherein the cell boundary is free of overlap with the front-side conductive contact and the back-side conductive contact in the second direction (D3).

15. The integrated circuit device of Claim 14, wherein the front-side conductive track (116; 216; 316; 416; 516) is configured to supply power to the at least one of the first transistor (102; 202; 302; 402; 502) and the second transistor (108; 208; 308; 408; 508) through the front-side conductive contact and/or is configured to transfer a signal to or from the at least one of the first transistor (102; 202; 302; 402; 502) and the second transistor (108; 208; 308; 408; 508) through the front-side conductive contact, and
wherein the back-side conductive track (118; 218; 318; 418; 518) is configured to supply power to the at least one of the first transistor (102; 202; 302; 402; 502) and the second transistor (108; 208; 308; 408; 508) through the back-side conductive contact and/or is configured to transfer a signal to or from the at least one of the first transistor (102; 202; 302; 402; 502) and the second transistor (108; 208; 308; 408; 508) through the back-side conductive contact.
